# EUROPÄISCHE PATENTSCHRIFT

(11) **EP 1 650 496 B1**
(45) Veröffentlichungstag und Bekanntmachung des Hinweises auf die Patenterteilung: **10.08.2011**
(21) Anmeldenummer: 05020710.9
(22) Anmeldetag: 22.09.2005
(51) Int. Cl.: F21V 31/03

(54) **Leuchtengehäuse mit Druckausgleichsvorrichtung**
Housing with a pressure relief device for luminaires
Boîtier de luminaire avec dispositif de compensation de pression

(30) Priorität: 21.10.2004 DE 102004051385
(43) Veröffentlichungstag der Anmeldung: 26.04.2006
(73) Patentinhaber: Zumtobel Lighting GmbH, 6850 Dornbirn (AT)
(72) Erfinder: Ladstätter, Gerald, 6833 Klaus (AT); Spiegel, Michael, 6850 Dornbirn (AT)
(74) Vertreter: Schmidt-Evers, Jürgen

(56) Entgegenhaltungen:
- EP-A1- 0 185 408
- DE-A1- 3 604 615
- US-A- 3 457 399
- US-A- 4 405 974
- US-A- 4 833 572
- US-B1- 6 352 358

## Beschreibung

Die vorliegende Erfindung betrifft ein Leuchtengehäuse gemäß dem Oberbegriff des Anspruchs 1, welches mittels einer Druckausgleichsvorrichtung gegen das Eindringen von Staub und Feuchtigkeit geschützt ist. Ein derartiges Leuchtengehäuse ist insbesondere zur Verwendung bei sog. Leuchten höherer Schutzart vorgesehen.

Leuchten höherer Schutzart finden bspw. in Feuchträumen oder Reinräumen Verwendung. In diesen Anwendungsgebieten ist es erforderlich, dass die Leuchte gegen das Eindringen von Feuchtigkeit und Staub geschützt ist und andererseits auch kein Staub aus der Leuchte austreten kann, der bspw. die Umgebung kontaminieren könnte. Ein luftdichtes Verschließen des Leuchtengehäuses würden in derartigen Fällen nicht unmittelbar zu einer Lösung des Problems führen, da durch Temperaturschwankungen verursachte Druckunterschiede zwischen dem Leuchteninnenraum und der Umgebung dazu führen können, dass durch einen undefinierten Druckausgleich Staub oder Wasser in das Leuchteninnere gelangen. Um diese Problematik zu vermeiden, sind Druckausgleichsvorrichtungen bekannt, über welche ein kontrollierter Druckausgleich zwischen Leuchteninnenraum und Umgebung ermöglicht und gleichzeitig das Ein- und Austreten von Staub oder Wasser verhindert wird.

Bekannte Druckausgleichsvorrichtungen weisen in der Regel ein Gehäuse oder eine Kammer auf, welche im Leuchteninnenraum oder an der Leuchtenaußenseite angebracht ist. Die Kammer weist zwei Öffnungen auf, wobei die Anordnung des Gehäuses derart erfolgt, dass die erste Öffnung mit der Umgebung und die zweite Öffnung mit dem Leuchteninneren in Verbindung steht. Der Innenraum der Kammer der Druckausgleichsvorrichtung verbindet dann die beiden Öffnungen, wobei die Öffnungen durch ein Filtermedium voneinander getrennt sind, um das Eindringen von Staub in das Leuchteninnere zu verhindern. Bei diesem Filtermedium kann es sich bspw. um eine Filtermatte, Filtergewebe, Filterschaum oder gleichartige Medien handeln.

Ein bekanntes Problem bei den bislang verwendeten Druckausgleichsvorrichtungen ist, dass diese bei einer ungünstigen Plazierung Wasser durch ihre Öffnungen ansaugen und dementsprechend die Gefahr besteht, dass Wasser in die Vorrichtung bzw. in das Innere der Leuchte gelangt. Hierbei ist ferner auch zu berücksichtigen, dass insbesondere bei Leuchten höherer Schutzart gefordert ist, dass diese auch gegen Spritzwasser geschützt sind und dementsprechend besondere Maßnahmen getroffen werden müssen, um das Eindringen von Wasser - insbesondere auch über die Druckausgleichsvorrichtung - zu vermeiden.

Aus der deutschen Offenlegungsschrift DE 36 04 615 A1 ist eine Druckausgleichsvorrichtung bekannt, welche an der Leuchtenaußenseite angeordnet ist und ein Labyrinth bildet, welches derart ausgebildet ist, dass eingedrungenes Wasser durch Schwerkraftwirkung selbständig wieder ausläuft ohne zuvor in das Leuchteninnere einzudringen. Erreicht wird dies dadurch, dass das Labyrinth eine Kammer bildet, welche mehrere versetzt angeordnete Öffnungen aufweist. Durch die mit der Umgebung der Leuchte in Verbindung stehenden sog. Kammeröffhungen kann zwar Wasser in die Druckausgleichskammer eindringen bzw. angesaugt werden, bei lagerichtigem Einbau der Druckausgleichsvorrichtung allerdings kann das Wasser schwerkraftbedingt aus der Kammer auch wieder ablaufen, ohne in das Leuchteninnere zu gelangen.

Nachteilig bei der Ausgestaltung der aus der DE 36 04 615 A1 bekannten Druckausgleichsvorrichtung ist, dass die Konstruktion verhältnismäßig aufwendig ist und ferner die Druckausgleichsvorrichtung das Aussehen der Leuchte beeinträchtigt.

Aus der US 4,833,572 ist ein Leuchtengehäuse mit einer Druckausgleichsvorrichtung bekannt, die innerhalb des Leuchtengehäuses angeordnet ist. Die Druckausgleichsvorrichtung umfasst einen U-förmigen Luftkanal, der einerseits eine Öffnung in das Innere des Leuchtengehäuses aufweist und andererseits eine Öffnung zum Außenbereich. Letztere ist derart angeordnet, dass im Kanal befindliches Wasser selbstständig abfließen kann.

Weitere Leuchten mit Druckausgleichsvorrichtungen sind aus den Schriften DE 36 04 615 A1, US 4,405,974, US 6,352,358 B1 und US 3,457,399 bekannt. Diese Druckausgleichsvorrichtungen weisen jeweils ein Filtermaterial auf.

Der vorliegenden Erfindung liegt dementsprechend die Aufgabe zugrunde, ein Leuchtengehäuse zu schaffen, welches mittels einer Druckausgleichsvorrichtung gegen das Eindringen von Staub und Feuchtigkeit geschützt ist, wobei die bei bekannten Druckausgleichsvorrichtungen bestehenden Probleme vermieden werden sollen.

Die Aufgabe wird durch ein Leuchtengehäuse mit einer Druckausgleichsvorrichtung gemäß den Merkmalen des Anspruchs 1 gelöst. Vorteilhafte Weiterbildungen der Erfindung sind Gegenstand der Unteransprüche.

Erfindungsgemäß wird also ein Leuchtengehäuse vorgeschlagen, welches mittels einer Druckausgleichsvorrichtung gegen das Eindringen von Staub und Feuchtigkeit geschützt ist, wobei die Druckausgleichsvorrichtung eine Kammer bildet, welche eine in das Innere des Leuchtengehäuses führende erste Öffnung sowie zwei, die Kammer mit der Umgebung verbindende Kammeröffnungen aufweist, wobei die Kammeröffnungen über ein Filtermedium von der ersten Öffnung getrennt sind und zumindest eine Kammeröffnung derart angeordnet ist, dass in der Kammer befindliches Wasser unter Einfluss der Schwerkraft selbständig abfließen kann. Erfindungsgemäß ist die Kammer innerhalb des Leuchtengehäuses angeordnet.

Kerngedanke der vorliegenden Erfindung ist also, die Druckausgleichsvorrichtung, welche derart ausgestaltet ist, dass in die Kammer eindringendes Wasser selbständig wieder abfließen kann, in das Leuchtengehäuse zu integrieren. Diese Lösung gestattet es, trotz allem die Anforderungen an Leuchten höherer Schutzart zu erfüllen und gleichzeitig das Aussehen der Leuchte nicht negativ beeinflussen zu müssen.

Um trotz der Verlegung der Druckausgleichsvorrichtung in das Leuchtengehäuse einen zuverlässigen Schutz gegen das Eindringen von Staub und Feuchtigkeit zu erzielen, können verschiedene Maßnahmen getroffen werden, die sicherstellen, dass in der Kammer befindliches Wasser unter Einfluss der Schwerkraft selbständig wieder abfließen kann. Hierzu kann bspw. vorgesehen sein, zumindest eine der beiden Kammeröffnungen über einen Schlauch mit einer Öffnung in dem Leuchtengehäuse zu verbinden. Auf der anderen Seite wäre es allerdings auch denkbar, die Druckausgleichsvorrichtung derart innerhalb des Leuchtengehäuses zu plazieren, dass zumindest eine der beiden Kammeröffnungen unmittelbar mit einer Öffnung in dem Leuchtengehäuse zusammenwirkt. Denkbar wäre in diesem Fall auch, dass zumindest Teile des Leuchtengehäuses die Kammer der Druckausgleichsvorrichtung begrenzen und dementsprechend ausschließlich eine einzige Öffnung in der entsprechenden Gehäusewand erforderlich ist.

Bei einigen Leuchten besteht die Möglichkeit, diese in unterschiedlicher Weise in einem zu beleuchtenden Raum zu montieren. Um in sämtlichen möglichen Montagepositionen den gewünschten Druckausgleich und gleichzeitig den Schutz gegenüber Staub und Wasser erzielen zu können, wird gemäß einer besonders vorteilhaften Weiterbildung der vorliegenden Erfindung vorgeschlagen, die Druckausgleichsvorrichtung verstellbar, bspw. drehbar innerhalb des Leuchtengehäuses anzuordnen. In diesem Fall sind vorzugsweise zwei Kammeröffnungen jeweils über Schläuche mit Öffnungen in dem Leuchtengehäuse verbunden, um entsprechend der jeweiligen Anordnung ein optimales Abfließen von in die Druckausgleichsvorrichtung eindringendes Wasser zu ermöglichen.

Insgesamt wird hierdurch eine Möglichkeit geschaffen, Leuchten höherer Schutzart zuverlässig zu schützen und gleichzeitig der erforderlichen Druckausgleich zu ermöglichen. Die Integration in das Leuchtengehäuse trägt dazu bei, dass das Aussehen der Leuchte nicht nachteilig beeinflusst wird.

Nachfolgend soll die Erfindung anhand der beiliegenden Zeichnung näher erläutert werden. Es zeigen:
- Fig. 1: eine Leuchte mit einem erfindungsgemäße ausgestalteten Leuchtengehäuse im Schnitt;
- Fig. 2: ein erstes Ausführungsbeispiel einer erfindungsgemäß ausgestalteten Druckausgleichsvorrichtung
- Fig. 3: ein vergrößerte Darstellung eines zweiten Ausführungsbeispiels der vorliegenden Erfindung im Schnitt; und
- Fig. 4: ein drittes Ausführungsbeispiel einer erfindungsgemäßen Druckausgleichsvorrichtung.

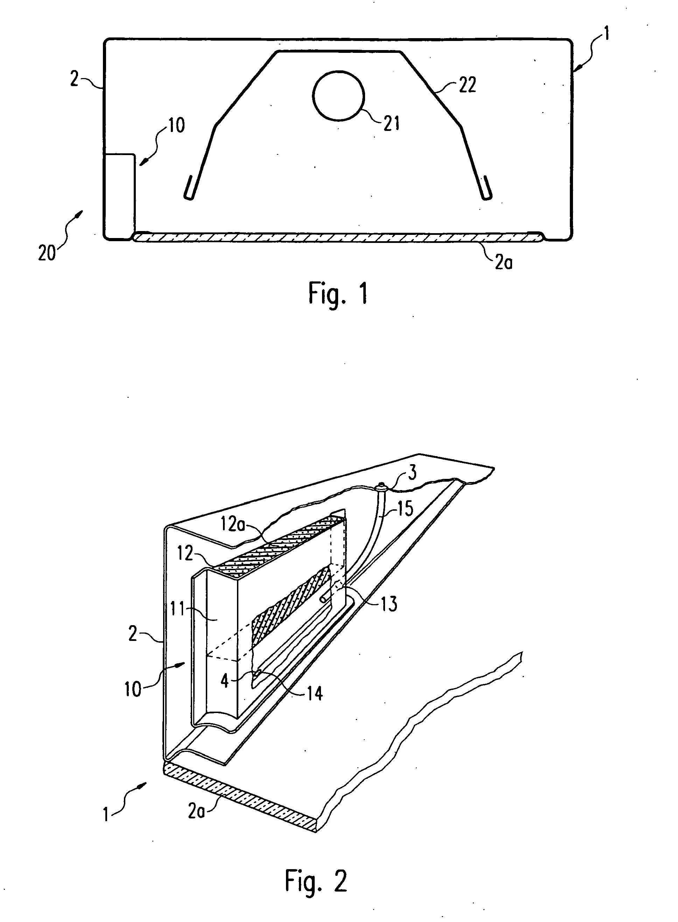

Fig. 1 zeigt eine allgemein mit dem Bezugszeichen 20 bezeichnete Leuchte, die bspw. in Feucht- oder Reinräumen zum Einsatz kommt. Es handelt sich hierbei um eine sog. Leuchte höherer Schutzart, welche bestimmte Anforderungen im Hinblick auf die Gefahr des Eindringens von Staub oder Flüssigkeit erfüllen muss. Hierfür ist zunächst erforderlich, dass das mit dem Bezugszeichen 1 bezeichnete Leuchtengehäuse eine möglichst gute Abdichtung des Innenraums der Leuchte 20 gegenüber der Umgebung sicherstellt.

Im dargestellten Ausführungsbeispiel ist das Leuchtengehäuse 1 durch einen länglichen, wannenartigen Gehäusekörper 2 gebildet, der mittels nicht näher dargestellter Befestigungselemente an der Decke oder Wand eines zu beleuchtenden Raumes angeordnet werden kann. An seiner Unterseite weist der Gehäusekörper 2 eine zur Lichtabgabe vorgesehene Lichtaustrittsöffnung auf, welche mit einer transparenten Abdeckung 2a verschlossen ist. Mittels Dichtungen wird erzielt, dass in dem Übergangsbereich zwischen dem Gehäusekörper 2 und der Abdeckung 2akein Austausch von Staub und Flüssigkeit stattfinden kann. Die innerhalb des Gehäuses 1 angeordneten Komponenten der Leuchte, also bspw. die Lichtquelle 21 sowie ein evtl. Reflektor 22 zur gerichteten Lichtabgabe sind damit zunächst vor Einflüssen aus der Umgebung der Leuchte 20 geschützt.

Zu berücksichtigen ist, dass sich innerhalb der Leuchte 20 die Temperatur sehr stark verändern kann. Ein Aktivieren der Lichtquelle 21 wird ein Aufheizen des Leuchteninnenraums zur Folge haben, während hingegen nach dem Abschalten der Lichtquelle 21 der Innenraum wieder abkühlt. Aufgrund dieser Temperaturdifferenzen können im Vergleich zur Umgebung der Leuchte 20 Druckunterschiede auftreten, die berücksichtigt werden müssen. Für den Fall, dass keine geeigneten Maßnahmen getroffen werden, könnten die durch Temperaturschwankungen hervorgerufenen Druckunterschiede zwischen Leuchteninnenraum und Umgebung zur Folge haben, dass die Dichtung zwischen Gehäusekörper 2 und transparenter Abdeckung 2a nicht mehr ordnungsgemäß funktioniert und aufgrund eines undefinierten Druckausgleichs Staub oder Wasser in das Leuchteninnere gelangt.

Um dies zu verhindern, ist eine Druckausgleichsvorrichtung 10 vorgesehen, welche erfindungsgemäß im Inneren des Leuchtengehäuses 1 angeordnet ist. Die genauere Ausgestaltung der erfindungsgemäßen Druckausgleichsvorrichtung 10 wird später noch näher erläutert. Wesentlich ist zunächst, dass die Druckausgleichsvorrichtung 10 zum einen mit dem Leuchteninneren und zum anderen mit der Umgebung der Leuchte in Verbindung steht und einen Druckausgleich zwischen beiden Bereichen ermöglicht. Gleichzeitig sind Maßnahmen vorgesehen, die verhindern, dass Staub in die Leuchte eindringen kann bzw. in die Umgebung abgeführt wird.

Ein bekanntes Problem dieser Druckausgleichsvorrichtungen besteht nun darin, dass - bspw. für den Fall, dass die Leuchte in einem Feuchtraum angeordnet ist - Flüssigkeit in die Druckausgleichsvorrichtung eindringen kann. Hierbei besteht dann die Gefahr, dass diese Flüssigkeit einen weiteren Druckausgleich zwischen dem Leuchteninnenraum und der Umgebung verhindert und dementsprechend wieder die zuvor geschilderten Probleme auftreten. Die Problematik des Eindringens von Wasser muss daher bei der Konstruktion der Druckausgleichsvorrichtung 10 berücksichtigt werden. Hierbei ist auch zu berücksichtigen, dass bei Leuchten höherer Schutzart allgemein Maßnahmen getroffen werden müssen, welche die Leuchte gegen Spritzwasser und dgl. schützen.

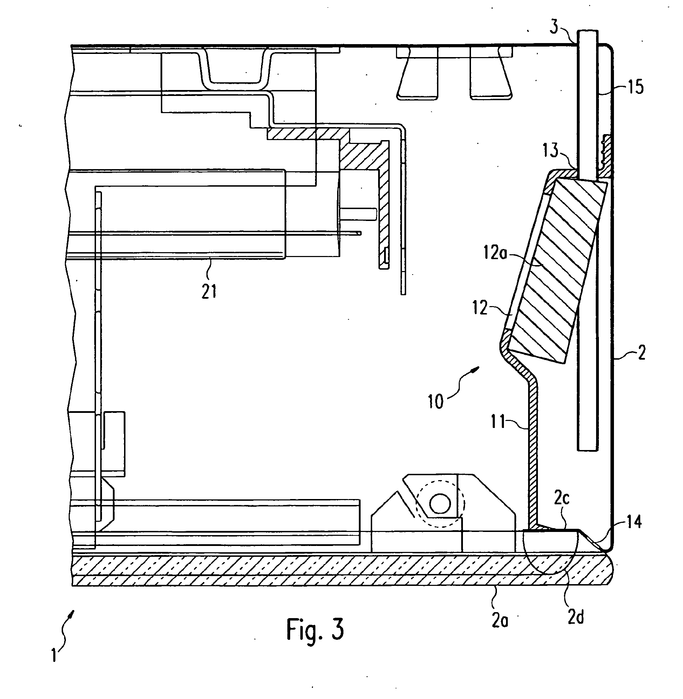

Erfindungsgemäß ist nunmehr die in das Leuchtengehäuse 1 integrierte Druckausgleichsvorrichtung 10 derart ausgestaltet, dass in gewünschter Weise ein Druckausgleich zwischen Leuchteninnenraum und Leuchtenumgebung ermöglicht wird und gleichzeitig Maßnahmen getroffen werden, die ein Ansammeln von Wasser innerhalb der Druckausgleichsvorrichtung 10 verhindern. Die erfindungsgemäße Ausgestaltung der Druckausgleichsvorrichtung 10 soll nachfolgend anhand von zwei in den Fig. 2 und 3 dargestellten Ausführungsbeispielen beschrieben werden.

Zentrales Element der Druckausgleichsvorrichtung 10 ist eine Kammer 11, über welche ein Druckausgleich zwischen dem Leuchteninnenraum und der Umgebung der Leuchte erfolgt. Damit dieser Druckausgleich ermöglicht wird, muss die Kammer 11 einerseits mit dem Leuchteninnenraum in Verbindung stehen und andererseits zur Umgebung hin offen sein. Dies wird zunächst durch eine erste Öffnung 12 ermöglicht, welche mit dem Leuchteninnenraum in Verbindung steht und entsprechend der Darstellung in Fig. 2 mit einem Filtermedium 12a ausgefüllt ist, welches das Ein- oder Austreten von Staubpartikeln in bzw. aus dem Leuchteninnenraum verhindern soll. Bei diesem Filtermedium 12a kann es sich bspw. um eine Filtermatte, Filtergewebe, Filterschaum oder andere vergleichbare Materialien handeln.

Der erforderliche Druckausgleich mit der Umgebung des Leuchtengehäuses wird nunmehr mit Hilfe einer weiteren Öffnung 13 in dem Gehäuse der Druckausgleichsvorrichtung 10 erzielt, welche mit der Leuchtenumgebung in Verbindung steht. Diese sog. Kammeröffnung 13 ist hierzu im dargestellten Ausführungsbeispiel über einen Schlauch 15 mit einer Öffnung 3 an der Oberseite des Leuchtengehäuses 2 verbunden. Hierdurch wird also die Möglichkeit geschaffen, dass über den Schlauch 15 Luft aus der Leuchtenumgebung angesaugt bzw. in die Umgebung abgegeben wird und dementsprechend ein Druckausgleich vollzogen wird.

Die erste Kammeröffnung 13 allein würde jedoch nicht das Problem des Eindringens bzw. Ansammelns von Wasser innerhalb der Kammer 11 der Druckausgleichsvorrichtung 10 lösen. Würde sich nämlich zuviel Wasser innerhalb der Kammer 11 ansammeln, so würde die Kammeröffnung 13 bzw. die Öffnung des Schlauchs 15 durch die Flüssigkeit abgedeckt werden und damit ein Druckausgleich zwischen dem Leuchteninneren und der Umgebung wieder verhindert werden. Um deshalb eine Ansammlung von Wasser zu vermeiden, ist eine zweite Kammeröffnung 14 vorgesehen, die derart ausgestaltet und angeordnet ist, dass sich in der Kammer 11 ansammelndes Wasser unter dem Einfluss der Schwerkraft selbständig aus der Kammer 11 abfließen kann. Diese zweite Kammeröffnung 14 steht also wiederum in Kontakt mit der Leuchtenumgebung, was im dargestellten Ausführungsbeispiel dadurch erzielt wird, dass die Außenwand des Leuchtengehäuses 2 zugleich auch die Außenwand der Druckausgleichsvorrichtung 10 bildet und dementsprechend eine in dieser Wand gebildete Öffnung 4 des Leuchtengehäuses 2 zugleich auch die mit der Leuchtenumgebung in Kontakt stehende zweite Kammeröffnung 14 bildet. Wesentlich ist, dass diese zweite Kammeröffnung 14 also an der Bodenseite bzw. zumindest im unteren Bereich der Druckausgleichsvorrichtung 10 angeordnet und derart ausgestaltet ist, dass Flüssigkeit ohne weiteres abfließen kann.

Es wäre denkbar, ausschließlich eine einzige Kammeröffnung, nämlich die untere Öffnung 14 zu verwenden, die dann beide Funktionen (Druckausgleich und Wasserablauf) erfüllt. Vorzugsweise sind allerdings - wie dargestellt - zwei Kammeröffnungen vorgesehen, da unabhängig von einem etwaigen Wasserabfluß über die Öffnung 14 nach wie vor ein Luftaustausch mit der Umgebung über die erste Kammeröffnung 13 bzw. den Schlauch stattfindet. Dementsprechend besteht auch nicht die Gefahr, dass Flüssigkeit aufgrund eines Unterdrucks in dem Leuchtengehäuse bzw. der Druckausgleichskammer 11 nicht durch die Öffnung 14 abfließen kann.

Wesentlich bei der erfindungsgemäßen Lösung ist, dass die Komponenten der Druckausgleichsvorrichtung vollständig in den Innenraum der Leuchte verlagert wurden. Mit Hilfe der zum Leuchteninnenraum führenden ersten Öffnung 12 sowie den beiden Kammeröffnungen 13 und 14 wird dann ein zuverlässiger Luftaustausch ermöglicht, so dass der angestrebte Druckausgleich erfolgen kann. Um den Austausch von Staubpartikeln zuverlässig zu vermeiden, ist ferner das Filtermedium 12a zumindest derart angeordnet, dass die beiden Kammeröffnungen 13 und 14 von der Öffnung 12 durch das Filtermedium 12a getrennt sind. Die Druckausgleichsvorrichtung 10 ist also bezüglich der Führung und des Eintritts der Umgebungsluft derart ausgestaltet, dass in das Leuchtengehäuse einströmende Luft das Filtermedium 12a als letztes durchströmt.

Im dargestellten Ausführungsbeispiel ist die erste Kammeröffnung 13 über den Schlauch 15 mit der Öffnung 3 in der Gehäuseoberseite verbunden, während hingegen die zweite Kammeröffnung 14 unmittelbar mit einer Öffnung in dem Leuchtengehäuse 2 zusammenwirkt bzw. durch diese Öffnung 4 selbst gebildet ist. Es wäre allerdings selbstverständlich auch denkbar, auch die zweite Kammeröffnung 14 der Druckausgleichsvorrichtung 10 über einen Schlauch mit einer entsprechenden Öffnung in dem Leuchtengehäuse 2 zu verbinden. Wesentlich hierbei ist, dass die Anordnung und Ausgestaltung derart erfolgt, dass zumindest über eine der beiden Kammeröffnungen 13 oder 14 Flüssigkeit selbständig ablaufen kann.

Die Verbindung beider Kammeröffnungen 13 und 14 über entsprechende Schläuche mit der Umgebung der Leuchte ist insbesondere dann allerdings von Vorteil, wenn die Leuchte auf unterschiedliche Art und Weise montiert werden kann. In einem derartigen Fall ist es für die zuverlässige Funktion der Druckausgleichsvorrichtung 10 erforderlich, dass diese entsprechend der Orientierung der Leuchte ausgerichtet ist. Durch die Verwendung von Schläuchen zur Verbindung mit der Leuchtenumgebung wird eine ausreichende Flexibilität erhalten, die es ermöglicht, die Druckausgleichsvorrichtung verstellbar in dem Leuchtengehäuse, insbesondere drehbar anzuordnen. In einem derartigen Fall kann somit dann die Anordnung der Druckausgleichsvorrichtung jederzeit an die entsprechende Montagesituation angepasst werden, so dass der Druckausgleich und das automatische Abführen von Flüssigkeit in zuverlässiger Weise erfolgt.

Ein zweites Ausführungsbeispiel der erfindungsgemäßen Druckausgleichsvornchtung 10 ist in Fig. 3 dargestellt, wobei gleiche Komponenten des Leuchtengehäuses 1und der Druckausgleichsvorrichtung 10 mit den gleichen Bezugszeichen versehen wurden.

Das zweite Ausführungsbeispiel entspricht im wesentlichen dem Ausführungsbeispiel von Fig. 2. Wiederum ist die erste der beiden Kammeröffnungen 13, 14 über einen Schlauch 15 mit einer Öffnung in dem Leuchtengehäuse 1 bzw. dem Gehäusekörper 2 verbunden. Der Schlauch erstreckt sich bis zu einer Position, die unterhalb des Filtermaterials 12a liegt, welches die zum Leuchteninnenraum führende Öffnung 12 abdeckt. Wiederum wird also die Luft derart geführt, dass das Filtermedium 12a als letztes durchströmt wird.

Die zum Abführen von Wasser vorgesehene zweite Kammeröffnung 14 ist an der Unterseite der Kammer 11 in dem nach innen ragenden Vorsprung 2c des Außenwand des Gehäusekörpers 2 angeordnet. Die Öffnung 14 befindet sich dabei außerhalb einer zwischen dem Gehäusekörper 2 und der Abdeckung 2a befindlichen Dichtung 2d, welche selbstverständlich derart angeordnet ist, dass sie die Öffnung 14 nicht verschließt. Durch den schmalen Spalt zwischen Gehäusekörper 2 und Abdeckung 2a kann dann das Wasser problemlos ablaufen.

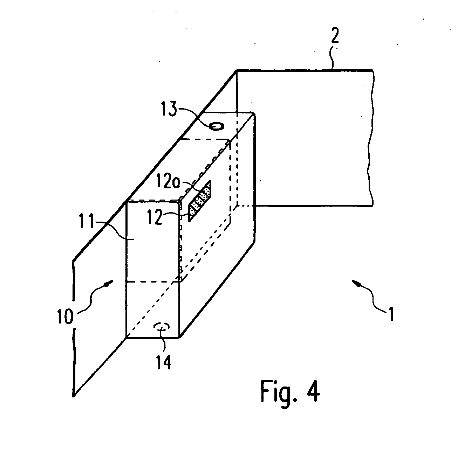

Ein drittes Ausführungsbeispiel der erfindungsgemäßen Druckausgleichsvorrichtung ist schließlich in Fig. 4 dargestellt. In diesem Fall sind zur Verbindung mit der Leuchtenumgebung keine Schläuche vorgesehen, stattdessen werden die Kammeröffnungen 13 und 14 der Druckausgleichsvorrichtung unmittelbar durch Öffnungen in dem Leuchtengehäuse 2 gebildet. Die erste Öffnung 13 befindet sich dabei an der Oberseite des Leuchtengehäuses 2, während hingegen die zweite Kammeröffnung 14 an der Bodenseite angeordnet ist und dementsprechend wiederum das selbständige Abfließen von Flüssigkeit ermöglicht. Beispielsweise könnte die zweite Kammeröffnung 14 wiederum derart angeordnet sein, dass das Wasser über eine zwischen dem Gehäusekörper 2 und der Abdeckung 2a befindliche Ablauföffnung abfließen kann. Auch bei diesem dritten Ausführungsbeispiel begrenzen zumindest Teile des Leuchtengehäuses die Kammer 11 der Druckausgleichsvorrichtung 10, so dass diese problemlos in das Leuchtengehäuse integriert ist. Selbstverständlich bestünde allerdings auch die Möglichkeit, die Druckausgleichsvorrichtung als vollständig separates Gehäuseteil in dem Leuchtengehäuse anzuordnen.

Erfindungsgemäß wird somit ein Leuchtengehäuse vorgeschlagen, welches mittels einer Druckausgleichsvorrichtung zuverlässig gegen das Eindringen von Staub und Feuchtigkeit geschützt ist. Die Integration der Druckausgleichsvorrichtung in den Innenraum der Leuchte gestattet es dabei, Nachteile im Erscheinungsbild der Leuchte zu vermeiden. Trotz allem ist jedoch sichergestellt, dass sich in der Druckausgleichsvorrichtung ansammelndes Wasser zuverlässig abfließen kann.

## Patentansprüche

1. Leuchtengehäuse (1), welches mittels einer Druckausgleichsvorrichtung (10) gegen das Eindringen von Staub und Feuchtigkeit geschützt ist,
wobei die Druckausgleichsvorrichtung (10) eine Kammer (11) bildet, welche
• eine in das Innere des Leuchtengehäuses (1) führende erste Öffnung (12) sowie
• mindestens eine die Kammer (11) mit der Umgebung verbindende Kammeröffnung (13, 14)
aufweist,
wobei die Kammer (11) der Druckausgleichsvorrichtung (10) innerhalb des Leuchtengehäuses (1) angeordnet ist,
wobei die mindestens eine Kammeröffnung (13, 14) derart angeordnet ist, dass in der Kammer (11) befindliches Wasser unter Einfluß der Schwerkraft selbständig abfließen kann,
**dadurch gekennzeichnet,**
**dass** die mindestens eine Kammeröffnung (13, 14) über ein Filtermedium (12a) von der ersten Öffnung (12) getrennt angeordnet ist und
**dass** die Kammer (11) über zwei Kammeröffnungen (13, 14) mit der Umgebung verbunden ist.

2. Leuchtengehäuse nach Anspruch 1,
**dadurch gekennzeichnet,**
**dass** zumindest eine Kammeröffnung (13, 14) über einen Schlauch (15) mit einer Öffnung (3, 4) in dem Leuchtengehäuse (1) verbunden ist.

3. Leuchtengehäuse nach Anspruch 1,
**dadurch gekennzeichnet,**
**dass** beide Kammeröffnungen (13, 14) über Schläuche (15) mit Öffnungen (3, 4) in dem Leuchtengehäuse (1) verbunden sind.

4. Leuchtengehäuse nach Anspruch 3,
**dadurch gekennzeichnet,**
**dass** die Druckausgleichsvorrichtung (10) verstellbar innerhalb des Gehäuses (1) angeordnet ist.

5. Leuchtengehäuse nach Anspruch 4,
**dadurch gekennzeichnet,**
**dass** die Druckausgleichsvorrichtung (10) drehbar angeordnet ist.

6. Leuchtengehäuse nach Anspruch 1 oder 2,
**dadurch gekennzeichnet,**
**dass** zumindest eine Kammeröffnung (13, 14) unmittelbar mit einer Öffnung (3, 4) in dem Leuchtengehäuse (1) zusammenwirkt.

7. Leuchtengehäuse nach einem der vorherigen Ansprüche,
**dadurch gekennzeichnet,**
**dass** zumindest Teile des Leuchtengehäuses (1) die Kammer (11) der Druckausgleichsvorrichtung (10) begrenzen.

8. Leuchtengehäuse nach einem der vorherigen Ansprüche,
**dadurch gekennzeichnet,**
**dass** das Filtermedium (12a) innerhalb der in das Innere des Leuchtengehäuses (1) führenden ersten Öffnung (12) angeordnet ist.

9. Leuchte (20) mit einem Leuchtengehäuse (1), welches einen wannenartigen Gehäusekörper (2) aufweist, in dem eine Lichtquelle (21) angeordnet ist und der mit einer zur Lichtabgabe vorgesehenen transparenten Abdeckung (2a) verschlossen ist,
**dadurch gekennzeichnet,**
**dass** das Leuchtengehäuse (1) mit einer Druckausgleichsvorrichtung (10) gemäß einem der vorherigen Ansprüche versehen ist.

10. Leuchte nach Anspruch 9,
**dadurch gekennzeichnet,**
**dass** die zumindest eine Kammeröffnung (13, 14) über eine zwischen dem Gehäusekörper (2) und der Abdeckung (2a) befindliche Ablauföffnung mit der Leuchtenumgebung verbunden ist.

## Claims

1. A luminaire housing (1) which is protected against the penetration of dust and moisture by means of a pressure-compensating device (10),
wherein the pressure-compensating device (10) forms a chamber (11), which has
• a first opening (12) leading into the interior of the luminaire housing (1), and also
• at least one chamber opening (13, 14) connecting the chamber (11) to the environment,
wherein the chamber (11) of the pressure-compensating device (10) is arranged inside the luminaire housing (1),
wherein the at least one chamber opening (13, 14) is arranged in such a way that water located in the chamber (11) can flow off independently under the influence of gravitational force,
**characterised in that**
the at least one chamber opening (13, 14) is arranged so as to be separated from the first opening (12) by way of a filter medium (12a), and
the chamber (11) is connected to the environment by way of two chamber openings (13, 14).

2. A luminaire housing according to claim 1,
**characterised in that**
at least one chamber opening (13, 14) is connected to an opening (3, 4) in the luminaire housing (1) by way of a tube (15).

3. A luminaire housing according to claim 1,
**characterised in that**
both chamber openings (13, 14) are connected to openings (3, 4) in the luminaire housing (1) by way of tubes (15).

4. A luminaire housing according to claim 3,
**characterised in that**
the pressure-compensating device (10) is arranged in an adjustable manner inside the housing (1).

5. A luminaire housing according to claim 4,
**characterised in that**
the pressure-compensating device (10) is arranged in a rotatable manner.

6. A luminaire housing according to claim 1 or 2,
**characterised in that**
at least one chamber opening (13, 14) co-operates directly with an opening (3, 4) in the luminaire housing (1).

7. A luminaire housing according to one of the previous claims,
**characterised in that**
at least portions of the luminaire housing (1) delimit the chamber (11) of the pressure-compensating device (10).

8. A luminaire housing according to one of the previous claims,
**characterised in that**
the filter medium (12a) is arranged inside the first opening (12) leading into the interior of the luminaire housing (1).

9. A luminaire (20) having a luminaire housing (1) which has a tub-like housing body (2) in which a light source (21) is arranged and which is closed by a transparent cover (2a) provided for light-emission,
**characterised in that**
the luminaire housing (1) is provided with a pressure-compensating device (10) according to one of the previous claims.

10. A luminaire according to claim 9,
**characterised in that**
the at least one chamber opening (13, 14) is connected to the luminaire environment by way of a run-off opening that is located between the housing body (2) and the cover (2a).

## Revendications

1. Boîtier de luminaire (1) protégé par un dispositif de compensation de pression (10) contre toute pénétration de poussière et d'humidité,
le dispositif de compensation de pression (10) formant une chambre (11) qui présente
- une première ouverture (12) menant à l'intérieur du boîtier de luminaire (1) ainsi que
- au moins une ouverture de chambre (13, 14) reliant la chambre (11) à l'environnement,
la chambre (11) du dispositif de compensation de pression (10) étant disposée à l'intérieur du boîtier de luminaire (1),
au moins une ouverture de chambre (13, 14) étant disposée de telle manière que de l'eau contenue dans la chambre (11) puisse s'écouler automatiquement sous l'effet de la force de gravité,
**caractérisé en ce que**
au moins une ouverture de chambre (13, 14) est disposée au-dessus d'un agent filtrant (12a) séparément de la première ouverture (12) et
la chambre (11) est reliée à l'environnement par le biais de deux ouvertures de chambre (13, 14).

2. Boîtier de luminaire selon la revendication 1, **caractérisé en ce qu'**au moins une ouverture de chambre (13, 14) est reliée par un tuyau flexible (15) à une ouverture (3, 4) dans le boîtier de luminaire (1).

3. Boîtier de luminaire selon la revendication 1, **caractérisé en ce que** les deux ouvertures de chambre (13, 14) sont reliées par des tuyaux flexibles (15) aux ouvertures (3, 4) dans le boîtier de luminaire (1).

4. Boîtier de luminaire selon la revendication 3, **caractérisé en ce que** le dispositif de compensation de pression (10) est disposé de manière réglable dans le boîtier (1).

5. Boîtier de luminaire selon la revendication 4, **caractérisé en ce que** le dispositif de compensation de pression (10) est disposé de manière rotative.

6. Boîtier de luminaire selon la revendication 1 ou 2, **caractérisé en ce qu'**au moins une ouverture de chambre (13, 14) coagit directement avec une ouverture (3, 4) dans le boîtier de luminaire (1).

7. Boîtier de luminaire selon l'une quelconque des revendications précédentes, **caractérisé en ce qu'**au moins des parties du boîtier de luminaire (1) délimitent la chambre (11) du dispositif de compensation de pression (10).

8. Boîtier de luminaire selon l'une quelconque des revendications précédentes, **caractérisé en ce que** l'agent filtrant (12a) est disposé dans la première ouverture (12) menant à l'intérieur du boîtier de luminaire (1).

9. Luminaire (20) doté d'un boîtier de luminaire (1) qui présente un corps de boîtier (2) de type cuve, contenant une source de lumière (21) et fermé par un recouvrement transparent (2a) prévu pour l'émission de lumière, **caractérisé en ce que** le boîtier de luminaire (1) est pourvu d'un dispositif de compensation de pression (10) selon l'une quelconque des revendications précédentes.

10. Luminaire selon la revendication 9, **caractérisé en ce qu'**au moins une ouverture de chambre (13, 14) est reliée par une ouverture de sortie située entre le corps de boîtier (2) et le recouvrement (2a) à l'environnement du boîtier.
